(19) Europäisches Patentamt
European Patent Office
Office européen des brevets

(11) **EP 4 062 464 B1**

(12) **EUROPÄISCHE PATENTSCHRIFT**

(45) Veröffentlichungstag und Bekanntmachung des Hinweises auf die Patenterteilung:
**27.03.2024 Patentblatt 2024/13**

(21) Anmeldenummer: **20824891.4**

(22) Anmeldetag: **23.11.2020**

(51) Internationale Patentklassifikation (IPC):
*G06N 3/065* (2023.01)   *G11C 11/24* (2006.01)
*H01L 29/93* (2006.01)   *H10N 97/00* (2023.01)
*G06N 3/082* (2023.01)   *G11C 11/22* (2006.01)
*G11C 11/403* (2006.01)   *G11C 11/54* (2006.01)

(52) Gemeinsame Patentklassifikation (CPC):
**H01L 29/93; G06N 3/065; G11C 11/221; G11C 11/54; H01L 28/40;** G06N 3/048; G06N 3/082; G11C 11/403

(86) Internationale Anmeldenummer:
**PCT/EP2020/083085**

(87) Internationale Veröffentlichungsnummer:
**WO 2021/099639 (27.05.2021 Gazette 2021/21)**

(54) **KAPAZITIVES SYNAPTISCHES BAUELEMENT UND VERFAHREN ZU DESSEN ANSTEUERUNG**

HIGH STROKE RATIO CAPACITIVE SYNAPTIC DEVICE AND METHOD OF DRIVING THE SAME

COMPOSANT SYNAPTIQUE CAPACITIF À RAPPORT DE COURSE ÉLEVÉ ET SON PROCÉDÉ DE COMMANDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.11.2019 DE 102019008095**
         **29.04.2020 EP 20172069**

(43) Veröffentlichungstag der Anmeldung:
**28.09.2022 Patentblatt 2022/39**

(73) Patentinhaber: **SEMRON GmbH**
**01067 Dresden (DE)**

(72) Erfinder:
• **DEMASIUS, Kai-Uwe**
**01324 Dresden (DE)**
• **KIRSCHEN, Aron**
**01309 Dresden (DE)**

(74) Vertreter: **Lippert Stachow Patentanwälte Rechtsanwälte**
**Partnerschaft mbB**
**Krenkelstraße 3**
**01309 Dresden (DE)**

(56) Entgegenhaltungen:
**WO-A1-2010/147588      US-A1- 2018 082 168**
**US-A1- 2018 268 970**

• **"FERROELECTRIC MEMORY CAPACITORS FOR NEURAL NETWORKS", NTIS TECH NOTES, US DEPARTMENT OF COMMERCE. SPRINGFIELD, VA, US, 1. September 1991 (1991-09-01), Seite 701, XP000264069, ISSN: 0889-8464**

**Beschreibung**

Die Erfindung betrifft ein kapazitives synaptisches Bauelement, bestehend aus einem Schichtaufbau aus Gateelektrode, mit einer mit der Gateelektrode verbundenen ersten dielektrischen Schicht, einer zweiten dielektrischen Schicht und einer mit der zweiten dielektrischen Schicht verbundenen Ausleseelektrode und einer zwischen der ersten und der zweiten dielektrischen Schicht angeordneten Zwischenschicht.

Die Erfindung betrifft auch eine Anordnung unter Verwendung eines kapazitiven synaptischen Bauelements und ein Verfahren zum Beschreiben und Auslesen eines erfindungsgemäßen kapazitiven synaptischen Bauelements.

Unter einem kapazitiven synaptischen Bauelement wird ein kapazitives Bauelement zur gewichteten Multiplikation in künstlichen neuronalen Netzen verstanden.

Künstliche neuronale Netze haben in den vergangenen Jahren eine steigende Bedeutung in Bild- und Objekterkennung und Datenverarbeitung gewonnen und werden zukünftig eine wichtige Relevanz haben in der Implementierung von künstlicher Intelligenz.

Künstliche neuronale Netze sind biologisch inspiriert und bestehen aus Neuronen, in welchen die Verarbeitung von Information stattfindet und diese sind mit vielen weiteren Neuronen über gewichtete Verbindungen (sogenannte Synapsen) verknüpft. Das Ausgangssignal eines Neuron wird dabei entweder stark abgeschwächt in einer solchen Verknüpfung oder gut übertragen zum nächsten Neuron, wobei diese synaptische Verknüpfung eine Plastizität aufweist, das heißt graduell gestärkt oder geschwächt werden kann. Die Eingangssignale eines Neurons nach der Gewichtung werden aufsummiert, bei biologischen neuronalen Netzen zeitlich integriert und bei Erreichen eines Schwellwertes feuert dieses Neuron ein neues Signal aus. In sogenannten mehrlagigen Perzeptronen, werden die Eingangssignale eines Neurons auch aufsummiert, dort jedoch nicht-linear verzerrt, z.B. in Form einer sigmoidalen Funktion oder Tangens hyperbolicus-Funktion oder einer Rectified Linear Unit (ReLU) .

Das Problem heutiger Rechnerarchitekturen besteht darin, dass diese zum größten Teil auf der sogenannten Von-Neumann Architektur mit einer strikten Trennung zwischen Speicher und Prozessor beruhen und, dass zur Berechnung von künstlichen Neuronalen Netzen ganz viele Multiplikationen mit Summationen nötig sind. Die synaptische Gewichtung stellt letztlich eine Multiplikation mit einem Gewicht dar und die Summation erfolgt an den Neuroneneingängen. Da nicht alle Gewichte in Prozessornähe gespeichert werden können müssen diese in der Regel vom Arbeitsspeicher in den Prozessor geladen werden und dann multipliziert und aufsummiert werden, was extrem energieaufwendig ist.

Aus diesem Grund wurden verschiedene neuromorphe Rechnerarchitekturen in den vergangenen Jahren entwickelt, welche eine energieeffiziente Umsetzung von künstlichen neuronalen Netzen ermöglichen soll. Beispielsweise sind Matrixstrukturen, in welchen die Gewichte gespeichert sind besonders geeignet, da die Gewichtung von künstlichen neuronalen Netzen als Vektor-Matrix Multiplikation aufgefasst werden kann. Der Eingangsvektor, welche an die Wortlinien einer Matrix angelegt werden, entsprechen dabei den Ausgangssignalen einer Lage Neuronen, diese werden an den Kreuzungspunkten der Matrix, in welchen die Gewichte als quasi Analogwerte gespeichert werden, multipliziert und an der Bitleitung werden die Signale aufsummiert. Das summierte Ausgangssignal an den Bitleitungen wird mit der nächste Lage Neuronen verbunden (Tsai et al.: Recent progress in analog memory-based accelerators for deep learning).

Beispiele zur Implementierung der Gewichtung in einer Matrix umfassen resistive Speicherbauelemente, wie Memristoren (US20180019011A1), Phase change memory oder Floating Gate Transistoren. Bei resistiven Speicherbauelementen erfolgt die Multiplikation dabei über das Ohmsche Gesetz: I=GxU, wobei die Spannung U der Eingang an der Wortleitung ist und G der frei einstellbare Leitwert des resistiven Speicherbauelementes ist. Der Strom I wird auf der Bitleitung aufsummiert. Auf diese Weise geschieht die Berechnung im Speicher direkt und der Datentransfer, wie bei der von-Neumann Architektur entfällt.

Ein essentieller Nachteil von resistiven Bauelementen ist, dass diese eine Verlustleistung haben. Aus diesem Grund ist die Implementierung mit kapazitiven Bauelementen von Vorteil, da diese im Idealfall nur eine Blindleistung besitzen und keinen statischen Stromverbrauch besitzen (Di Ventra et al.: Circuit elements with memory- memristors, memcapacitors, and meminductors, Proceedings of the IEEE oder WO2016068886A1, US5146542A, WO1991018360A1).

Es wurden bereits verschiedene Bauelemente zur Implementierung solcher memkapazitiven Bauelemente vorgeschlagen.

Den meisten memkapazitiven Bauelementen ist gemein, dass die Einstellung der Kapazität über die Gleichung $C = \varepsilon_r \varepsilon_0 \cdot \dfrac{A}{d}$ erfolgt und man kann Bauelemente unterteilen in solche welche eine Variation des Plattenabstands d, der Fläche A oder der relativen dielektrischen Konstante $\varepsilon_r$ ausnutzen. Beispiele für Bauelemente mit Variation des Plattenabstands d sind Memristor-ähnliche Bauelemente, wobei die Dotierungsfront von Sauerstoffvakanzen den Plattenabstand eines Kondensators manipuliert (US20120014170A1, WO2011025495A1). Ebenso sind Mikromechanische (Emara et al.: Non-volatile low-power crossbar memcapacitor-based memory), bei welchen der Plattenabstand mechanisch eingestellt wird, veröffentlicht. Als Bauelement mit Variation des Plattenabstand d kann auch ein Metal-Ferroelektrikum-Halbleiter-Metal Schichtaufbau dienen, wobei die Sperrschichtweite im Halbleiter nicht-flüchtig durch den Polarisationszustand des Ferroelektrikums eingestellt wird (DE102014105639B3, US5524092A1, Min et al.: Tristate Memory Using Ferroelectric-Insulator-Semiconductor Heterojunctions for 50 % Increased Data Storage). Die Sperrschichtweitenvariation geht mit einer Veränderung des Plattenabstands einher.

Ein Beispiel für ein Bauelement mit Flächenvariation ist in US2019303744A1 oder Wang et al.: Capacitive neural network with neuro-transistors veröffentlicht. Die Veröffentlichung umfasst Memristoren mit paralleler parasitärer Kapazität und einer Serienkapazität, wobei die parallele parasitäre Kapazität eine deutlich geringe Kapazität aufweisen muss, als die Serienkapazität, was in dem genannten Beispiel durch eine kleine Fläche realisiert wird. Die parasitäre Kapazität wird durch den Memristor kurzgeschlossen, wenn eine hohe Gesamtkapazität eingestellt werden muss. Beispiele für Bauelemente mit Variation der Dielektrizitätskonstante finden sich in Zheng et al.: Artificial Neural Network Based on Doped HfO2 Ferroelectric Capacitors with Multilevel Characteristics oder Driscoll et al.: Memory metamaterials. Gänzlich an der Konzepte basieren auf Bauelemente auf Basis von Ionen (Krems et al.: Ionic Memcapacitive Effects in Nanopores) oder dem Tunneleffekt (Martinez et al.: Solidstate memcapacitor).

Da man in einem synaptischen Bauelement ein möglichst hohes Verhältnis aus minimaler und maximaler Kapazität (dynamisches Verhältnis) erzielen möchte, um möglichst viele Kapazitätswerte speichern zu können, ist es notwendig einen großen Kontrast zwischen minimalen und maximalen Plattenabstand d im Falle von Bauelementen mit variablen Plattenabstand zu erzielen. Problem hierbei ist, dass ein sehr großes d für die minimale Kapazität, die laterale Skalierung zu kleinen Technologieknoten des Bauelementes einschränken würde. Eine Streukopplung bei großen Plattenabstand d zu Nachbarzellen ist dominant und unerwünscht. Ein sehr kleines d für die maximale Kapazität würde andererseits zu sehr großen Tunnelströmen zwischen den Kapazitätsplatten führen. Beispielsweise müsste bei einem Hubverhältnis zwischen minimaler und maximaler Kapazität von >1:100 und einer maximalen Dicke d von 30 nm eine minimale Dicke von 0.3 nm eingestellt werden für die maximale Kapazität. Bei solchen Dicken tritt direktes Tunneln auf und der Vorteil kapazitiver Bauelemente einer geringen Verlustleistung würde zunichtegemacht.

Ein veränderte Plattengröße A hätte ebenfalls ein laterales Skalierungsproblem und eine Variation der relativen Dielektrizitätskonstante $\varepsilon_r$ schränkt die Materialauswahl ein, oder ist nur mit geringem dynamischen Hubverhältnis möglich.

In Patent WO002018069359A1 wurde bereits eine kapazitive Matrixstruktur vorgestellt, welche eine Schicht mit veränderlicher Abschirmlänge besitzt, jedoch hauptsächlich zur Speicherung digitaler Informationen diente und Verfahren beschrieb wie einzelne Speicherzellen ausgewählt werden können, was bei neuromorphen Anwendungen weniger relevant ist.

In der US 2018/0166448 wird eine Speicherzelle mit ferroelektrischen Dielektrika und deren Herstellungsverfahren beschrieben. Auch wenn sich diese Speicherzelle hinsichtlich Aufgabe und Funktion von der vorliegenden Erfindung unterscheidet, ist darin ein physischer Aufbau beschrieben, der mit dem erfindungsgemäßen Aufbau vergleichbar ist. Aus diesem Grunde wird nachfolgend von diesem Stand der Technik ausgegangen. Das Patent beschreibt einen verbesserten DRAM Speicher, wobei die Geschwindigkeit in einem FinFET erhöht wird durch ein Ferroelektrikum im Gatedielektrikum und zum anderen die Retention optimiert wird durch geringere Subthreshold Leckströme (negative Kapazität). Diese technische Lösung beschreibt jedoch keine variable Kapazität mit nichtflüchtigem Speichereffekt, enthält aber folgenden Schichtaufbau: Erste Metallschicht - Pufferschicht - ferroelektrische Schicht - Schicht mit Ladungsfangstellen - isolierende Schicht - zweite Metallschicht. Die Schicht mit Ladungsfangstellen kann aus einem leitendem, einem halbleitendem, isolierendem Material oder Graphen bestehen. Diese fungiert in diesem Zusammenhang aber nicht als Abschirmschicht, sondern als weitere Speicherschicht neben dem Ferroelektrikum. Eine gute Abschirmschicht müsste schnellen Ladungsträgertransfer ermöglichen, was mit der Schicht in US 2018/0166448 nicht möglich ist, da diese potentialfrei/floatend ist und ein Ladungsträgertransfer wenn überhaupt nur langsam möglich ist über den Tunneleffekt.

Ebenso hohe Relevanz in Zukunft werden nicht nur synaptische Bauelemente mit zwei Anschlüssen, sondern mit einem zusätzlichen Modulationsanschluss, um Verknüpfungen in Abhängigkeit der Aktivität einer weiteren Größe zu variieren. Solche Möglichkeiten wurden bisher nur für resistive Bauelemente vorgestellt (Yang et al.: Memristive Physically Evolving Networks Enabling the Emulation of Heterosynaptic Plasticity).

Weiterhin spielen neben der gewichteten Multiplikation mit festen Gewichten, auch Multiplikationen zwischen völlig variablen Größen in künstlichen neuronalen Netzen eine Rolle. Multiplikationen zwischen analogen Spannungswerten erfordert jedoch eine aufwendige Analogschaltung und es wäre günstig eine solche Multiplikation, ähnlich der gewichteten Multiplikation, mit einem einzelnen elektronischen Bauelement durchzuführen.

Aufgabe dieser Erfindung besteht darin, ein kapazitives synaptisches Bauelement mit mehreren nichtflüchtigen Speicherzuständen anzugeben, welches ein hohes kapazitives Hubverhältnis ermöglicht, ohne dabei den Plattenabstand, die Fläche oder die relative Dielektrizitätskonstante zu verändern, oder die laterale Skalierfähigkeit einzuschränken. Zudem soll es einen weiteren Modulationsanschluss geben.

Erfindungsgemäß wird diese Aufgabe anordnungsseitig durch ein Kapazitives synaptisches Bauelement mit den Merkmalen des Anspruches 1 gelöst.

Ausführungsformen hierzu sind in den abhängigen Ansprüchen 2 bis 10 dargestellt.

Die Aufgabe wird auch durch eine Verwendung des erfindungsgemäßen Bauelementes in einer Anordnung gemäß Anspruch 11 gelöst.

Weiterhin wird die erfindungsgemäße Aufgabenstellung durch ein Verfahren gemäß Anspruch 12 gelöst. Verfahrensseitige Ausgestaltungen sind in den abhängigen Ansprüchen 13 bis 16 dargestellt.

Ein kapazitives synaptisches Bauelement der eingangs genannten Art wird erfindungsgemäß dadurch gestaltet, dass die Zwischenschicht als Schicht mit einstellbarem Abschirmverhalten in einem elektrischen Feld, ausgehend von der Gateelektrode in Richtung zu der Ausleseelektrode, ausgebildet ist und die Zwischenschicht mit einer oder mehreren eigenen, einen Ladungszufluss in oder einen Ladungsabfluss aus der Zwischenschicht realisierenden Kontaktierungen versehen ist.

Die elektrischen Feldlinien von der Gateelektrode werden entweder bei starker Abschirmung der Zwischenschicht auf bzw. in der Zwischenschicht enden, bei schwacher Abschirmung enden die Feldlinien hauptsächlich auf der Ausleseelektrode. Das heißt durch die Abschirmung der Zwischenschicht wird eine Durchkopplung des elektrischen Feldes von der Gateelektrode zur Ausleseelektrode gesteuert. Ein hohes Hubverhältnis wird vor allem durch eine effektive Abschirmung der Zwischenschicht sichergestellt, sodass das elektrische Feld nahezu komplett unterbrochen ist. Dies ist ein fundamentaler Unterschied zu dem eingangserwähnten Stand der Technik, bei dem das Hubverhältnis z.B. durch eine Variation des Kondensatorplattenabstands erreicht wird, mit den genannten Nachteilen. Hier kann auch mit dünnen Schichten ein ausreichend hohes dynamisches Verhältnis erzielt werden, was eine bessere laterale Skalierfähigkeit erlaubt. Zudem besitzt das Bauteil einen dritten Anschluss an der Zwischenschicht was eine weitere Modulation ermöglicht.

Zweckmäßigerweise ist vorgesehen, dass die erste dielektrische Schicht und/oder die Zwischenschicht als aktives Speichermedium ausgebildet ist. Die Stärke der Abschirmung der Zwischenschicht kann nichtflüchtig gespeichert werden, entweder indem die Zwischenschicht selber über eine Speicherfunktion verfügt, und/oder mit einem Zusammenspiel aus der ersten dielektrische Schicht und der Zwischenschicht, wobei die Speicherfunktion von der ersten dielektrischen Schicht ausgeht.

Die erste dielektrische Schicht kann als aktives Speichermedium verschiedene Ladungszustände speichernd ausgebildet sein.

Eine dielektrische Schicht, welche verschiedene Ladungszustände speichern kann, verschiebt den Spannungspunkt der Abschirmung in der Zwischenschicht, d.h. beispielsweise können Kapazitäts-Gatespannungskurven in einer Zwischenschicht aus einem Halbleiter durch die Ladungszustände verschoben werden. Die Ladungszustände sind nichtflüchtig gespeichert.

In einer Ausführungsform ist hierzu vorgesehen, dass die erste dielektrische Schicht in der Funktion als aktives Speichermedium aus einem ferroelektrischen Material besteht. Ein ferroelektrisches Material verfügt über elektrische Polarisationszustände, welche durch Domänenbildung beliebig zwischen einer positiven und negativen Polarisierung eingestellt werden kann.

In dem Fall, dass die erste dielektrische Schicht als aktives Speichermedium verschiedene Ladungszustände speichernd ausgebildet ist, kann die erste dielektrische Schicht in der Funktion als aktives Speichermedium Ladungsfangstellen besitzen.

Ladungsfangstellen können beispielsweise durch eine Nitridschicht oder einer polykristallinen Schicht in der ersten dielektrischen Schicht ausgebildet sein. Die Ladungen werden in der Schicht nichtflüchtig eingefangen.

Wenn die erste dielektrische Schicht und/oder die Zwischenschicht als aktives Speichermedium ausgebildet ist, kann vorgesehen werden, dass die Zwischenschicht als aktives Speichermedium verschiedene Widerstandswerte speichernd ausgebildet ist, indem die Zwischenschicht einen veränderlichen Widerstand aufweist, und sie ihren Widerstandswert nicht flüchtig speichern kann.

Neben der ersten dielektrischen Schicht kann also auch die Zwischenschicht selber über eine nichtflüchtige Speicherfunktion verfügen. Ein hoher Widerstand führt zu einem geringen Zufluss von abschirmenden Ladungen und damit einer Transmission des elektrischen Feldes von der Gateelektrode zur Ausleseelektrode. Ein geringer Widerstand der Zwischenschicht führt zu einer starken Abschirmung.

Hierbei ist es möglich, dass die Zwischenschicht aus einem Metall-Isolator-Übergangs-Material, einem memristiven Material oder einem Phase-Change-Memory besteht.

Ein Metall-Isolator-Übergang wurde beispielsweise in Vanadiumdioxid beobachtet, wobei eine Bandlücke geschlossen und geöffnet werden kann (z.B. durch Temperatur, Druck, optisch oder elektrische Felder). Dies führt zu einer veränderten mobilen Ladungsträgerkonzentration und damit Abschirmung. In einem memristiven Material (z.B. Titandioxid oder Tantaloxid) wird der Widerstand durch mobile Sauerstoffvakanzen verändert. In einem Phase-Change-Memory Material findet ein Phasenwechsel von einer amorphen zu einer kristallinen Phase statt, was mit einer Widerstandsänderung einhergeht.

In einer weiteren Ausführung kann vorgesehen sein, dass die Zwischenschicht aus einem Halbleitermaterial besteht und eine Nichtlinearität in einem Kapazitäts-Spannungsverhältnis einer kapazitiven Kopplung zwischen Gatelektrode und Ausleseelektrode aufweist.

Ein Halbleitermaterial eignet sich gut als Zwischenschicht um eine wechselnde Abschirmung zu erzielen. Wird der Halbleiter in Inversion oder Akkumulation durch die Gatespannung getrieben ist die Abschirmung sehr stark, im Falle einer vollständigen Verarmung koppelt das Feld zur Ausleseelektrode durch, und die Abschirmung ist schwach. Damit ergibt sich für einen bestimmten Gatespannungsbereich ein kapazitives Kopplungsfenster. Da die Inversions- und Akkumulationsschichten sehr dünn sind, vor allem bei starker Inversion bzw. Akkumulation, kann die Halbleiterschicht ebenfalls dünn ausgestaltet werden und trotzdem ein hohes dynamisches Hubverhältnis erzielt werden, was ein wesentlicher Unterschied zu DE102014105639B3 und US5524092A1 darstellt.

In einer weiteren Ausführungsvariante kann vorgesehen sein, dass die Zwischenschicht seitliche hochdotierte p- und n-Gebiete besitzt, und der dazwischenliegende Bereich nur schwach dotiert ist oder intrinsisch, unter Ausbildung eines psn- oder pin-Gebietes.

Die seitliche dotierten p-und n-Gebiete ermöglichen eine Injektion von Löchern und Elektronen und damit gute Inversion und Akkumulation des Halbleitergebietes. Hierdurch wird symmetrisches Abschirmverhalten hinsichtlich positiver und negativer Gatespannungen erzielt. Symmetrisches Verhalten ist in synaptischen Bauelementen wesentlich, um hohe Genauigkeit zu erzielen (Tsai et al.: Recent progress in analog memory-based accelerators for deep learning). Zudem eröffnet der psn- bzw. pin-Übergang eine weitere Modulationsmöglichkeit durch Anlegen einer lateralen Spannungsdifferenz. Das s in psn soll eine schwache Dotierung im Vergleich zu den p- und n-Gebieten kennzeichnen.

Weiterhin kann vorgesehen werden, dass zwischen der ersten dielektrischen Schicht und der Ausleseelektrode (5) ein Halbleiterbereich angeordnet ist, der einen ersten Teilbereich, der die Zwischenschicht bildet und einen zweiten Teilbereich aufweist, der mit einer Ladungsträgerverarmung versehen ist, so dass er die zweite dielektrische Schicht bildet.

Ein verarmter Halbleiter kann als annähernd dielektrische Schicht aufgefasst werden, sodass dieser die zweite dielektrische Schicht bilden kann. Damit besteht die Zwischenschicht und die zweite dielektrische Schicht aus einem durchgehenden Halbleitergebiet, wobei die dielektrische Schicht durch eine Verarmung gekennzeichnet ist. Die Ausleseelektrode kann dabei durch ein dotiertes Halbleitergebiet darunter ausgebildet sein oder durch ein Metallgebiet auf der Halbleiterunterseite. Vorteil dieser Anordnung ist, dass die Zwischenschicht und die zweite dielektrische Schicht aus einem zusammenhängenden Halbleitermaterial bestehen kann, was eine einfachere Fertigung erlaubt.

Mit einer Anordnung unter Verwendung eines erfindungsgemäßen kapazitiven synaptischen Bauelements besteht die Lösung der erfindungsgemäßen Aufgabenstellung darin, dass eine Matrix aus einer Mehrzahl kapazitiver synaptischer Bauelemente besteht, bei der von jedem kapazitiven synaptischen Bauelement die Wortleitung mit der Gateelektrode verbunden ist, die Ausleseelektrode mit der Bitleitung und die Zwischenschicht mit einer Abschirmleitung verbunden wird, wobei im Falle von seitlichen dotierten Gebieten für jedes dotierte Gebiet Abschirmleitungen vorhanden sind, wobei die Abschirmleitung der Bitleitung entsprechend ausgeführt ist und die Bitleitungen einen Winkel ungleich Null, vorzugsweise 90°, zu den Wortleitungen bilden.

Für die Berechnung künstlicher neuronaler Netze müssen viele Vektor-Matrix-Multiplikationen durchgeführt werden, wobei sich die Gewichte in der Matrix befinden. Hierzu ist es vorteilhaft die synaptischen Bauelemente in einer Matrix anzuordnen. Die Gateelektroden des vorher beschriebenen kapazitiven synaptischen Bauelements wird dabei mit Wortleitungen verbunden, die Ausleseelektroden mit Bitleitungen und die Anschlüsse der Zwischenschicht wird mit Abschirmleitungen verbunden. Die Abschirmleitungen sind dabei parallel zu den Bitleitungen, welche wiederum senkrecht zu den Wortleitungen angeordnet sind. An den Wortleitungen wird das Eingangssignal, also die Werte der Vektoren angelegt, welche in den kapazitiven synaptischen Bauelementen gewichtet (abhängig von der eingestellten Abschirmung) werden und an den Bitleitungen wird das summierte Ergebnis ausgelesen. Das Schreiben erfolgt zwischen der Abschirmleitung und der Wortleitung.

Die verfahrensseitige Lösung der erfindungsgemäßen Aufgabenstellung zum Beschreiben und Auslesen eines erfindungsgemäßen kapazitiven synaptischen Bauelements besteht in folgenden fallweise definierten Schritten:

a. Bei einer nichtflüchtigen Einstellung der Abschirmung eine Schreibspannung wird zwischen der Gateelektrode und der Zwischenschicht angelegt und eine graduelle Beschreibung in Form der Einstellung verschiedener elektrischer Zustände des aktiven Speichermediums entweder über eine unterschiedliche Schreibpulshöhe, Schreibpulsdauer oder Schreibpulsanzahl erzielt werden kann.

Das heißt es liegt eine Potentialdifferenz zwischen Gatelektrode und Zwischenschicht vor und beispielsweise können Ladungszustände im ersten Dielektrikum gespeichert werden. Im Falle von Ladungsfangstellen würden die Ladungen zum Beispiel durch quantenmechanisches Tunneln injiziert werden. Im Falle eines Ferroelektrikum kann dies durch eine Änderung des Polarisationszustandes erfolgen. Bei einem einstellbaren Widerstand in der Zwischenschicht erfolgt das Schreiben beispielsweise durch eine Herbeiführung eines Metall-Isolator-Übergangs oder Bewegung von Sauerstoffvakanzen. Die verschiedenen Zustände können dabei entweder durch Variation der Schreibpulsdauer, durch Variation der Schreibpulshöhe oder Variation der Schreibpulsanzahl eingestellt werden, d.h. es wird eine quasi-analoge Wertspeicherung erzielt.

b. Bei einer flüchtigen Einstellung der Abschirmung wird fallweise an der Zwischenschicht eine Gleichspannung oder eine symmetrische Sperr- oder Durchlassspannung an den pin- oder psn-Übergang angelegt.

Neben der nichtflüchtigen Einstellung der Abschirmung kann diese auch durch eine Spannung an der Zwischenschicht flüchtig eingestellt werden. Im Falle von seitlichen p- und n-Gebieten kann eine Sperr- oder Durchlassrichtung an die laterale pin- bzw. psn-Diode eine Verarmung oder Anreicherung von mobilen Ladungsträgern bewirken und damit eine Abschirmung einstellen. Zudem kann das Anlegen einer identischen Gleichspannung an den Anschlüssen der Zwischenschicht, im Falle eines Halbleitermaterials, eine Verschiebung des Gatespannungsbereiches der Verarmung bewirken und damit eine Abschirmung/Transmission einstellen (Verschiebung von Kapazitäts-Spannungskurven).

c. Im Falle a) wird beim Auslesen der kapazitiven Kopplung zwischen Gateelektrode und Ausleseelektrode die Zwischenschicht geerdet, und/oder im Falle von b) beim Auslesen sind die Spannungsverhältnisse an der Zwischenschicht wie bei b) geschildert, ausgebildet sind.

d. In beiden Fällen a) und b) wird beim Auslesen an der Gateelektrode ein veränderliches Spannungssignal angelegt, an der Ausleseelektrode ein Strom oder eine Ladungsänderung in Abhängigkeit vom Zustand der Abschirmung gemessen wird.

Beim einfachen Auslesen ohne zusätzliche nicht-flüchtige Modulation wird die Zwischenschicht geerdet und ein Wechselspannungssignal an die Gateelektrode angelegt. Abhängig von der Abschirmung in der Zwischenschicht findet eine Durchkopplung zur Ausleseelektrode statt und beispielsweise ein Wechselstrom der Ladungsänderung kann dort detektiert werden.

Im Falle des Auslesens mit zusätzlicher nichtflüchtiger Modulation der Zwischenschicht, bleiben die Spannungsverhältnisse an der Zwischenschicht so wie sie nötig sind um eine Modulation zu erzielen und das Wechselsignal wird wieder an die Gateelektrode angelegt.

In einer Anwendung des erfindungsgemäßen Verfahrens auf die erfindungsgemäße Anordnung, d.h. die Matrix kann vorgesehen werden, dass beim Auslesen die veränderlichen Spannungssignale an alle Wortleitungen parallel angelegt werden und eine gewichtete Multiplikation an den Kreuzungspunkten stattfindet, sowie die Ströme oder die Ladungsänderungen in der Bitleitung sich summieren. Dabei entsprechen die Eingänge, d.h. die Werte der Vektoren der Vektor-Matrixmultiplikation den Wechselsignalen an den Wortleitungen und die summierten Ergebnisse aus der Matrix entsprechen den Ströme oder akkumulierten Ladungen der Bitleitungen.

In dem Falle einer Gestaltung bei der die Zwischenschicht seitliche hochdotierte p- und n-Gebiete besitzt, und der dazwischenliegende Bereich nur schwach dotiert ist oder intrinsisch, unter Ausbildung eines psn- oder pin-Gebietes ausgebildet ist, kann vorgesehen sein, dass das Schreiben des aktiven Speichermediums zusätzlich moduliert werden kann, indem eine symmetrische Sperr- oder Durchlassspannung an den pin- oder psn-Übergang angelegt wird.

Durch aktive Verarmung oder Anreicherung der Zwischenschicht mit den psn- oder pin Übergängen kann ein Beschreiben des ersten Dielektrikums unterdrückt bzw. unterstützt werden, dadurch, dass ausreichend Ladungen auf der Zwischenschicht notwendig sind, um ein ausreichend hohes Feld in der ersten dielektrischen Schicht zu erzielen. Im Falle von Verarmung koppelt das Feld hauptsächlich zur Ausleseelektrode durch und damit ist der Potentialabfall über dem ersten Dielektrikum zum Beschreiben niedriger.

Mit einer Gestaltung, bei der das Bauelement zur Modellierung eines Sigmoid oder ReLU Neurons dient, werden während des Dropout Algorithmus Bauelemente durch eine symmetrische Sperr- oder Durchlassspannung (22) an dem pin- oder psn-Übergang ein- oder abgeschaltet.

Beim Training von neuronalen Netzen kann overfitting auftreten, was unerwünscht ist. Dies kann gemindert werden kann, indem manche Neuronen ausgeschaltet werden während des Trainings und dann schrittweise dazu geschaltet werden. Das kapazitive synaptische Bauelement hat auch eine prinzipielle Eignung zur Modellierung von Rectified Linear Unit (ReLU) und Sigmoid Neuronen, da die Übertragungsfunktion der kapazitiven Kopplung ein ähnliches Verhalten zeigt. Diese Neuronen könnten durch Flutung oder Verarmung der Zwischenschicht mit Ladungsträger ausgeschaltet oder eingeschaltet werden.

In einem weiteren Verfahren zum Schreiben der Anordnung, kommt entweder Fowler-Nordheim Tunneln oder Injektion von heißen Ladungsträgern zum Einsatz kommen kann, wobei diese im pin- oder psn-Übergang durch Anlegen einer Spannung generiert werden können.

Beim Schreiben der ersten Dielektrischen Schicht mit Ladungsfangstellen können Ladungsträger in diese Fangstellen injiziert werden entweder durch Fowler-Nordheim Tunneln oder Injektion von heißen Ladungsträgern. Zur Generation von heißen Ladungsträgern kann auch der laterale psn- bzw. pin-Übergang ausgenutzt werden. Im Sperrbereich können bei ausreichend großer Sperrspannung genügend heiße Ladungsträger generiert werden.

Die Erfindung soll nachfolgend anhand mehrerer Ausführungsbeispiele näher erläutert werden. Die zugehörigen Zeichnungen zeigen:

Fig. 1: Genereller Aufbau des kapazitiven synaptischen Bauelementes mit typischer kapazitiver Kopplung zwischen Gateelektrode und Ausleseelektrode nach Anspruch 1 und 8.

Fig. 2: Aufbau eines kapazitiven synaptischen Bauelementes mit seitlichen p dotierten und n dotierten Gebieten nach Anspruch 9.

Fig. 3: Aufbau eines kapazitiven synaptischen Bauelementes mit seitlicher Dotierung und einem zweigeteilten Halbleitergebiet nach Anspruch 10.

Fig. 4: Aufbau eines kapazitiven synaptischen Bauelementes mit veränderlichem Widerstand nach Anspruch 6.

Fig. 5: Anordnung des kapazitiven synaptischen Bauelements in einer Matrix nach Anspruch 11.

Fig. 6: Kapazitives synaptisches Bauelement mit ferroelektrischen Material als erste dielektrische Schicht oder Ladungsfangstellen in der ersten dielektrischen Schicht nach Anspruch 4 und 5.

Fig. 7: Graduelles Schreiben des aktiven Speicherdielektrikums nach Anspruch 12 mit Variation der Schreibpulshöhe, Schreibpulslänge oder Schreibpulsanzahl.

Fig. 8: Auslesen des kapazitiven synaptischen Bauelementes mit einem veränderlichen Spannungssignal an der Gateelektrode nach Anspruch 12 und zugehörige nicht-flüchtig gespeicherter Kapazitäts-Spannungskurven.

Fig. 9: Flüchtige Einstellung der Abschirmung mit symmetrischer Durchlass- oder Sperrspannung an dem pin-Übergang nach Anspruch 12b, c, d (zusammen mit veränderlichen Spannungssignal an der Gateelektrode zum Auslesen) und zugehöriger Kapazitäts-Spannungskurve.

Fig. 10: Flüchtige Einstellung der Abschirmung mittels Gleichspannung an der Zwischenschicht nach Anspruch 12b, c, d (zusammen mit veränderlichen Spannungssignal an der Gateelektrode zum Auslesen) und zugehöriger Kapazitäts-Spannungskurve.

Fig. 11: Moduliertes Schreiben des aktiven Speicherdielektrikums mit einer symmetrische Durchlass- oder Sperrspannung an dem pin-Übergang und zugehöriger Kapazitäts-Spannungskurve nach Anspruch 14.

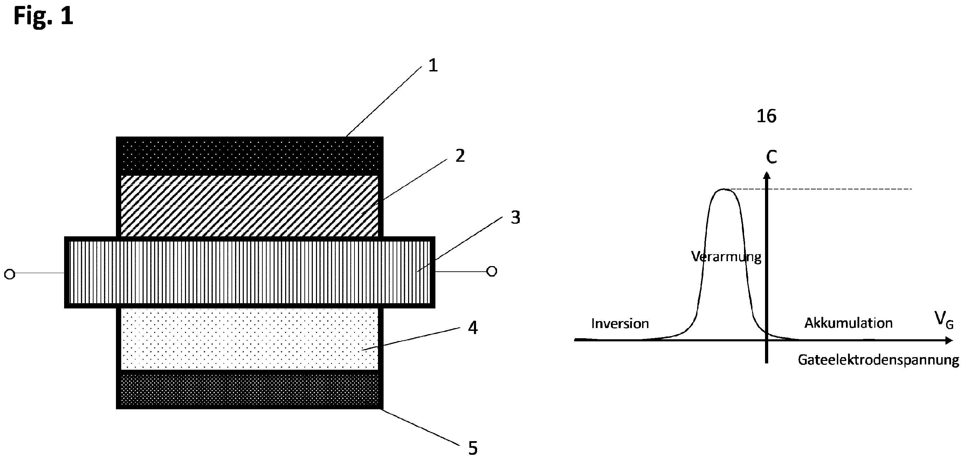

Die Zwischenschicht (3) kann ein elektrisches Feld von der Gateelektrode (1) ausgehend gut abschirmen oder zu der unteren Ausleseelektrode (5) transmittieren. Diese Transmission geht mit einer kapazitiven Kopplung (16) einher, wobei das Hubverhältnis zwischen Transmission und Abschirmung sehr groß sein kann. Das aktive Speichermedium justiert letztlich den Grad der Kopplung (16) für eine bestimmte Spannung und es soll im Stande sein mehrere Zustände speichern zu können, um eine quasi Analogwertbildung zu ermöglichen. Fig. 1 zeigt den generellen Aufbau mit Gateelektrode (1), erstem Dielektrikum (2), Zwischenschicht (3) mit seitlichen Anschlüssen, zweiten Dielektrikum (4) und Ausleseelektrode (5). Wenn die Zwischenschicht (3) aus einem Halbleitermaterial besteht entsteht als Kapazitäts-Spannungskurve zwischen Gateelektrode und Ausleseelektrode die in Fig. 1 rechts abgebildete Kurve. Im Falle von Inversion und Akkumulation schirmt der Halbleiter das elektrische Feld ab und bei vollständiger Verarmung wird das Feld transmittiert. Da die Inversions- und Akkumulationsschicht sehr dünn sind, kann der Halbleiter auch wenige Nanometer dick sein, und dennoch ein hohes dynamisches Hubverhältnis des Bauelements ermöglichen.

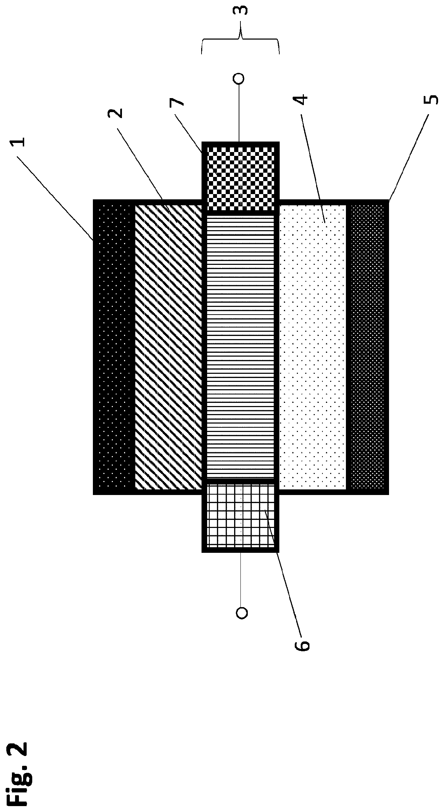

Fig. 2 zeigt denselben Aufbau mit lateralen p (6) und n(7) Gebieten, wobei diese eine Injektion von Löchern und Elektronen ermöglichen und damit symmetrisches Verhalten. Zudem kann eine zusätzliche Modulationsspannung angelegt werden. Das (p) und n (7) Gebiet erhalten jeweils einen eigenen Anschluss.

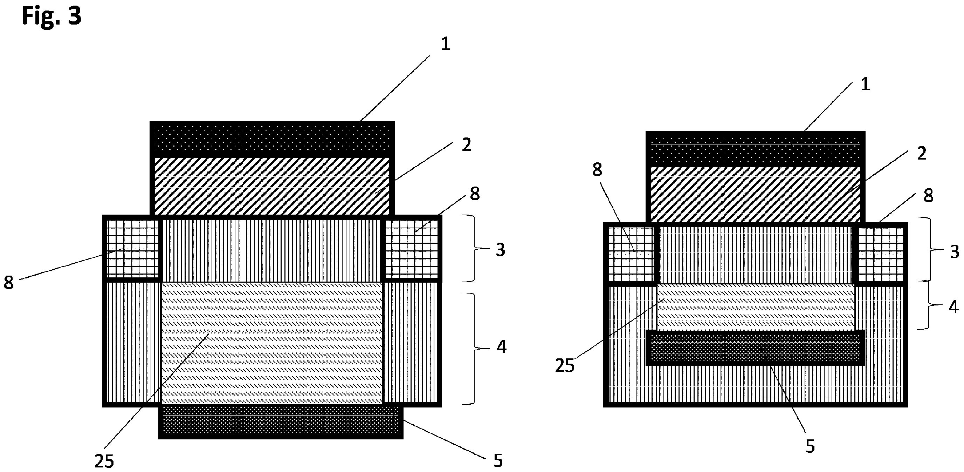

Wie in Fig. 3 dargestellt, kann die zweite dielektrische Schicht (4) auch aus einem verarmten Halbleitergebiet (25) bestehen und somit zusammen mit der Zwischenschicht (3) ein zusammenhängendes Halbleitergebiet bilden. Die Ausleseelektrode (5) kann als dotiertes Gebiet ausgeführt sein, wie in Fig. 3 rechts abgebildet oder als metallisches Gebiet unter dem Halbleiter. Vorteil dieser Anordnung wäre ein zusammenhängendes Halbleitergebiet und damit eine einfachere Herstellung.

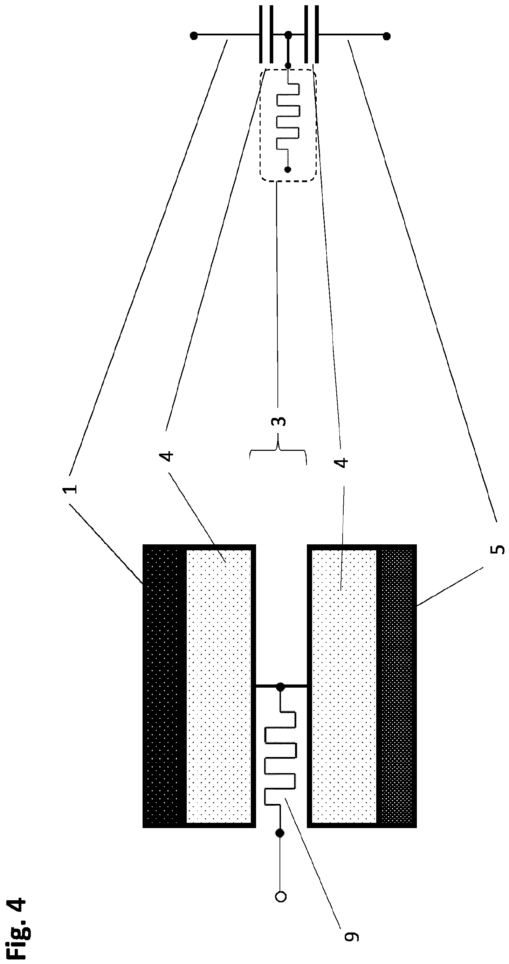

Die Abschirmung der Zwischenschicht (3) kann z.B., wie in Fig. 4 dargestellt durch einen einstellbaren Widerstand (9) der Zwischenschicht erfolgen. Dies kann auch nichtflüchtig erfolgen, z.B. durch einen Memristor, einem Metall-Isolator-Übergang oder einem Phase-Change-Memory. Bei hohem Widerstand werden in die Zwischenschicht (3) nicht genügend abschirmende Ladungen geliefert, sodass eine geringe Abschirmung erzielt wird.

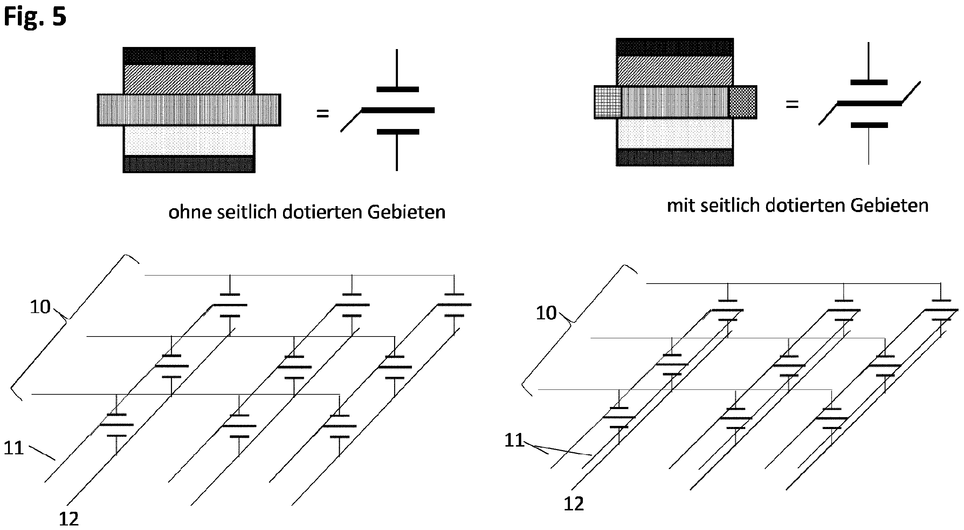

In Fig. 5 ist Matrixanordnung mehrerer kapazitiver synaptischer Bauelemente gezeigt. Dabei werden die Wortleitungen (10) mit den Gateelektroden (1) verbunden und die Eingangssignale angelegt. Die Ausleseelektrode (5) wird mit der Bitleitung (12) verbunden und an den Bitleitungen (12) werden die Signale aufsummiert. Die Zwischenschicht (3) wird mit Abschirmleitungen (11) verbunden. Bei seitlichen p(6) und n(7) Gebieten liegen zwei Abschirmleitungen (11) für jedes Gebiet vor. Die Matrix ermöglicht eine effiziente Ausführung einer Vektor-Matrix Multiplikation.

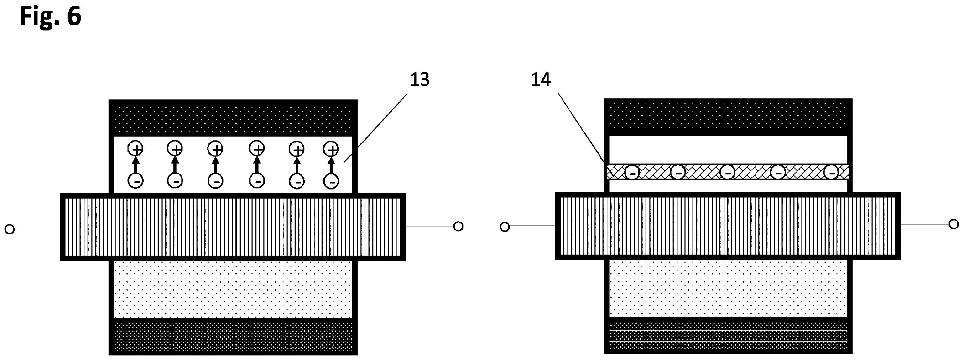

In Fig. 6 bildet die erste dielektrische Schicht (2) das aktive Speichermedium. Dies kann, wie links ein Ferroelektrikum (13) sein, wobei die Polaristionsladung den Ladungszustand abbildet oder die erste dielektrische Schicht (2) besitzt Ladungsfangstellen (14), welche den Ladungszustand speichern.

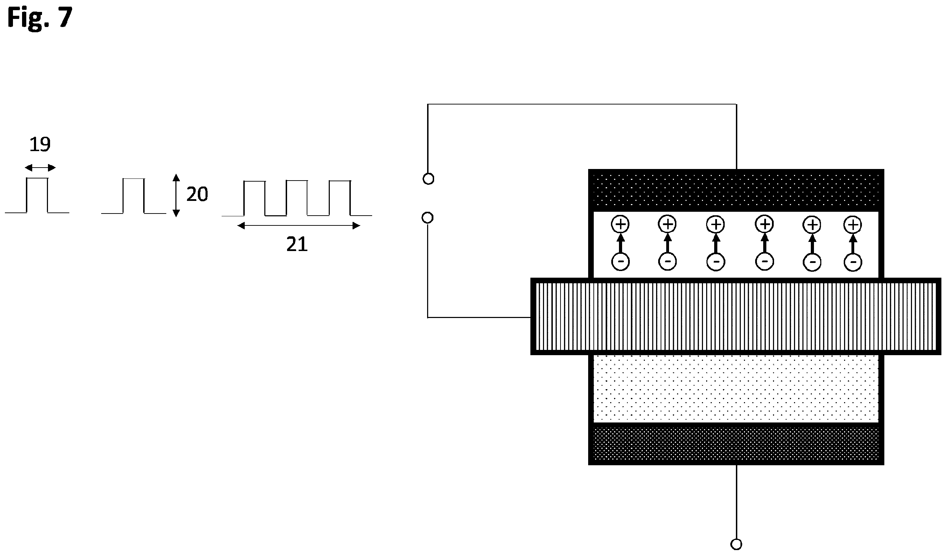

Bei Beschreiben (Fig. 7) des aktiven Speichermediums wird eine Potentialdifferenz (Schreibspannung) zwischen Gateelektrode (1) und Zwischenschicht (3) erzeugt. Die verschiedenen Speicherzustände können durch eine Veränderung der Schreibpulslänge (19), der Schreibpulshöhe (20) oder Schreibpulsanzahl (21) eingestellt werden. Im Falle von einem Ferroelektrikum (13) geht dies mit einer graduellen Änderung des Polarisationszustands einher oder im Falle von Ladungsfangstellen (14) geht dies mit einem unterschiedlich starken quantenmechanischen Tunnel von Ladungsträgern der Zwischenschicht (3) einher.

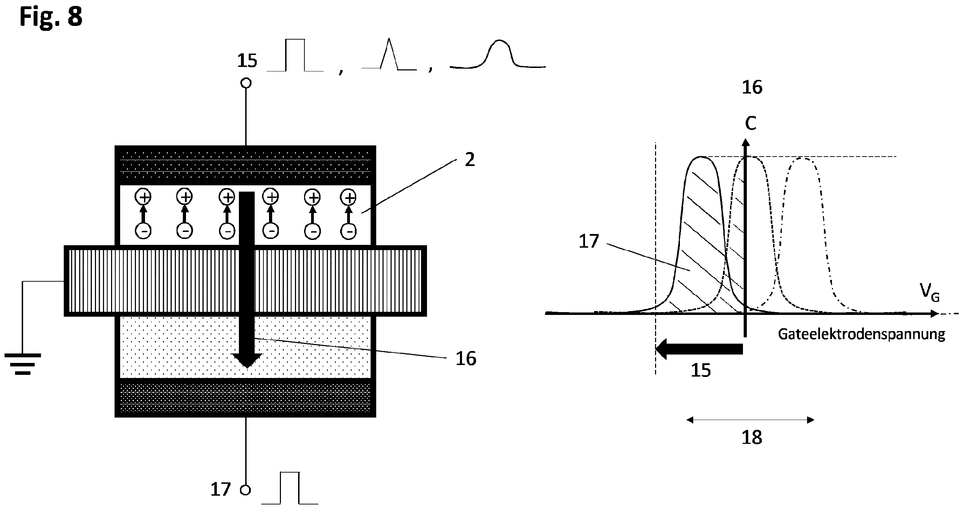

Nach dem Schreiben werden die nichtlinearen Kapazitäts-Spannungskurven (16), wie in Fig. 8 rechts dargestellt, verschoben (18). Beim Auslesen wird ein veränderliches Spannungssignal (15) an die Gateelektrode (1) angelegt, während die Zwischenschicht (3) geerdet sein kann. Dabei wird an der Ausleseelektrode (5) ein Strom oder eine Ladungsänderung (17) gemessen, welche von der Abschirmung der Zwischenschicht (3) abhängt. Die Ladungsmenge (17) ist dabei proportional zu der Fläche unter der Kapazitäts-Spannungskurve (16), welche von dem veränderlichen Spannungssignal (15) an der Gateelektrode (1) abgetastet wird. Bei der beispielhaft nach rechts verschobenen Kapazitäts-Spannungskurve in Fig. 8 wäre die Ladungsänderung (17) sehr klein.

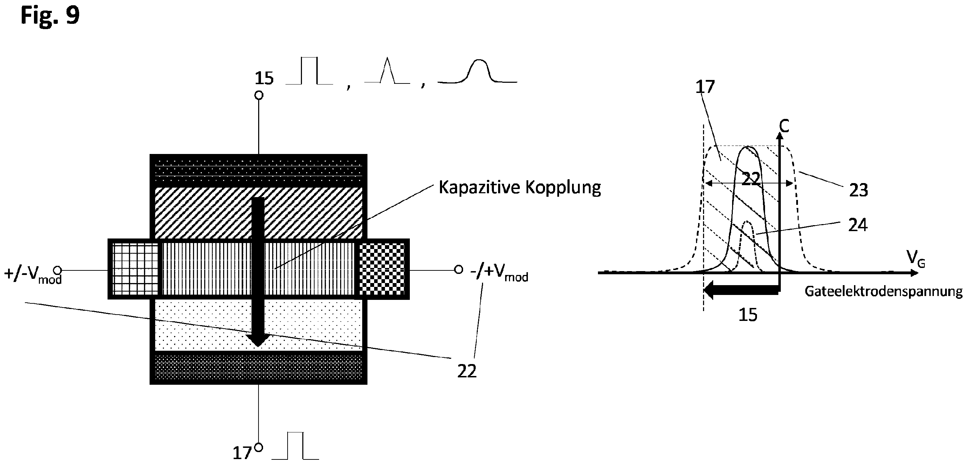

Ebenfalls ist es möglich, wie in Fig. 9 dargestellt die kapazitive Kopplung flüchtig durch eine symmetrische Sperr- oder Durchlassspannung (22) an den pin- bzw. psn-Übergängen zu verändern. Dabei wird die Zwischenschicht (3) mit mobilen Ladungsträgern verarmt oder geflutet. Die entsprechenden Kapazitäts-Spannungskurven sind rechts in Fig. 9 dargestellt und für den Fall der Verarmung werden die Kurven breiter (23), im Falle einer Flutung werden die Kurven schmaler und niedriger (24) und können auch ganz ausgeschaltet werden. Das beim Auslesen angelegte veränderliche Spannungssignal (15) an der Gateelektrode (1) sorgt bei einer Verarmung für eine große Ladungsänderung (17) an der Ausleseelektrode (5).

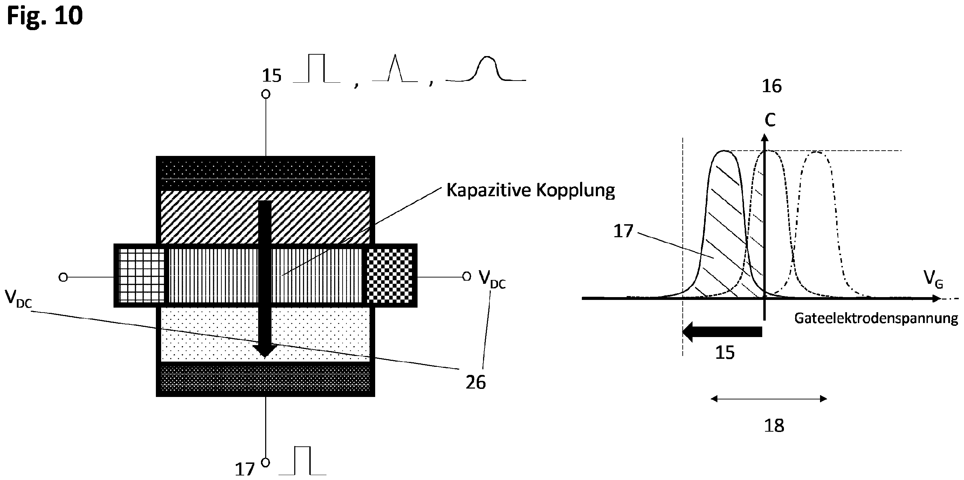

Die Verschiebung der Kapazitäts-Spannungskurven kann nicht nur durch Ladungszustände im Dielektrikum erzielt werden (Fig. 8), sondern auch flüchtig durch eine Gleichspannung (26) an der Zwischenschicht (3), wie in Fig. 10 dargestellt. Das Auslesen erfolgt dann auch durch ein veränderliches Spannungssignal (15) an der Gateelektrode (1) und der gemessenen Ladungsänderung (17) an der Ausleseelektrode (5).

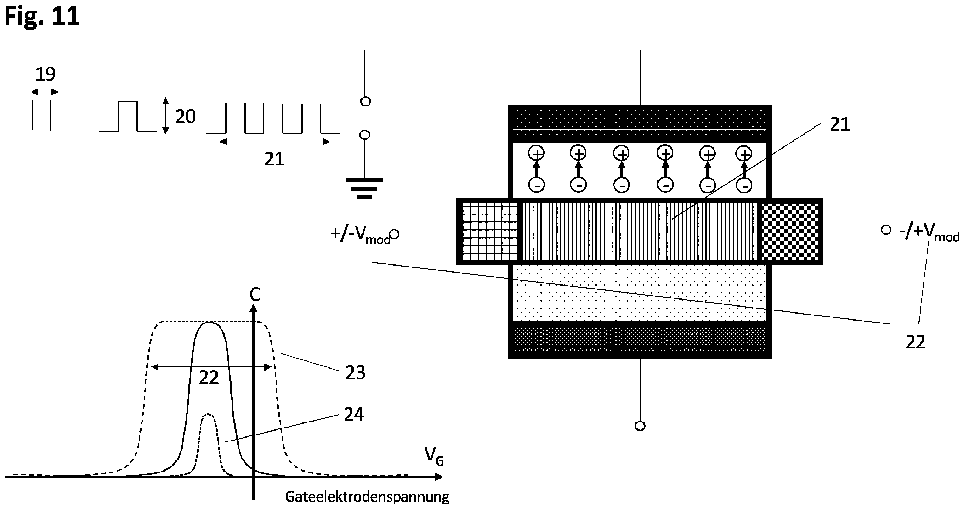

Das Schreiben des aktiven Speichermediums kann auch moduliert werden, indem die lateralen pin-Übergänge in der Zwischenschicht (3) mit einer Durchlass- oder Sperrspannung (22) beaufschlagt wird, wie in Fig. 11 dargestellt. Im Falle einer Ladungsträgerverarmung in der Zwischenschicht, können nicht ausreichend Ladungsträger geliefert werden, um ein ausreichend hohes elektrisches Feld in der ersten dielektrischen Schicht (2) zum Schreiben zu gewährleisten. Das Feld koppelt hauptsächlich zur Ausleseelektrode (5) durch und der Spannungsabfall über der ersten dielektrischen Schicht (2) ist zu gering oder vermindert. Bei einer Ladungsträgerflutung kehrt sich das Bild um. Auf diese Weise kann das Beschreiben des kapazitiven synaptischen Bauelementes zusätzlich moduliert werden.

## Bezugszeichenliste

1 - Gateelektrode
2 - Erste dielektrische Schicht
3 - Zwischenschicht
4 - Zweite dielektrische Schicht
5 - Ausleseelektrode
6 - p dotiertes Gebiet
7 - n dotiertes Gebiet
8 - dotiertes Gebiet
9 - veränderlicher Widerstand, welcher seinen Widerstandswert nichtflüchtig speichern kann
10 - Wortleitungen
11 - Abschirmleitungen
12 - Bitleitungen
13 - ferroelektrisches Material
14 - Ladungsfangstellen
15 - Veränderliches Spannungssignal
16 - Kapazitive Kopplung zwischen Gatelektrode und Ausleseelektrode
17 - Strom oder Ladungsänderung
18 - Verschiebung der Kapazitiven Kopplung
19 - Schreibpulsdauer
20 - Schreibpulshöhe
21 - Schreibpulsanzahl
22 - Symmetrische Sperr- oder Durchlassspannung
23 - Sperrrichtung
24 - Durchlassrichtung
25 - zweiter Teilbereich des Halbleiters, welcher eine Ladungsträgerverarmung aufweist
26 - Gleichspannung

## Patentansprüche

1. Kapazitives synaptisches Bauelement nämlich ein kapazitives Bauelement zur gewichteten Multiplikation in künstlichen neuronalen Netzen, bestehend aus einem Schichtaufbau aus Gateelektrode (1), mit einer mit der Gateelektrode verbundenen ersten dielektrischen Schicht (2), einer zweiten dielektrischen Schicht (4) und einer mit der zweiten dielektrischen Schicht (4) verbundenen Ausleseelektrode (5) und einer zwischen der ersten dielektrischen Schicht (2) und der zweiten dielektrischen Schicht (4) angeordneten Zwischenschicht (3), **dadurch gekennzeichnet, dass** die Zwischenschicht (3) als Schicht mit einstellbarem Abschirmverhalten in einem elektrischen Feld, ausgehend von der Gateelektrode (1) in Richtung zu der Ausleseelektrode (5), ausgebildet ist und die Zwischenschicht mit einer oder mehreren eigenen, einen Ladungszufluss in oder einen Ladungsabfluss aus der Zwischenschicht realisierenden Kontaktierungen versehen ist.

2. Kapazitives synaptisches Bauelement nach Anspruch 1, **dadurch gekennzeichnet, dass** die erste dielektrische Schicht (2) und/oder die Zwischenschicht (3) als aktives Speichermedium ausgebildet ist.

3. Kapazitives synaptisches Bauelement nach Anspruch 2, **dadurch gekennzeichnet, dass** die erste dielektrische Schicht (2) als aktives Speichermedium verschiedene Ladungszustände speichernd ausgebildet ist.

4. Kapazitives synaptisches Bauelement nach Anspruch 3, **dadurch gekennzeichnet, dass** das die erste dielektrische Schicht (2) in der Funktion als aktives Speichermedium aus einem ferroelektrischen Material (13) besteht.

5. Kapazitives synaptisches Bauelement nach Anspruch 3, **dadurch gekennzeichnet, dass** die erste dielektrische Schicht (2) in der Funktion als aktives Speichermedium Ladungsfangstellen (14) besitzt.

6. Kapazitives synaptisches Bauelement nach Anspruch 2, **dadurch gekennzeichnet, dass** die Zwischenschicht (3) als aktives Speichermedium verschiedene Widerstandswerte speichernd ausgebildet ist, indem die Zwischenschicht (3) einen veränderlichen Widerstand (9) aufweist, und sie ihren Widerstandswert nicht flüchtig speichernd ausgebildet ist.

7. Kapazitives synaptisches Bauelement nach Anspruch 6, **dadurch gekennzeichnet, dass** die Zwischenschicht aus einem Metall-Isolator-Übergangs-Material, einem memristiven Material oder einem Phase-Change-Memory besteht.

8. Kapazitives synaptisches Bauelement nach einem der Ansprüche 1 bis 5, **dadurch gekennzeichnet, dass** die Zwischenschicht (3) aus einem Halbleitermaterial besteht und eine Nichtlinearität in einem Kapazitäts-Spannungsverhältnis einer kapazitiven Kopplung (16) zwischen Gatelektrode (1) und Ausleseelektrode (5) aufweist.

9. Kapazitives synaptisches Bauelement nach Anspruch 8, **dadurch gekennzeichnet, dass** die Zwischenschicht (3) seitliche hochdotierte p- (6) und n- (7) Gebiete besitzt, und der dazwischenliegende Bereich nur schwach dotiert ist oder intrinsisch, unter Ausbildung eines lateralen psn- oder pin-Gebietes ausgebildet ist.

10. Kapazitives synaptisches Bauelement nach Anspruch 8 oder 9, **dadurch gekennzeichnet, dass** zwischen der ersten dielektrischen Schicht und der Ausleseelektrode (5) ein Halbleiterbereich angeordnet ist, der einen ersten Teilbereich, der die Zwischenschicht (3) bildet und einen zweiten Teilbereich (25) aufweist, der mit einer Ladungsträgerverarmung versehen ist, sodass er die zweite dielektrische Schicht (4) bildet.

11. Anordnung unter Verwendung eines kapazitiven synaptischen Bauelements nach einem der Ansprüche 1 bis 10, **dadurch gekennzeichnet, dass** eine Matrix aus einer Mehrzahl kapazitiver synaptischer Bauelemente besteht, bei der von jedem kapazitiven synaptischen Bauelement die Wortleitung (10) mit der Gateelektrode (1) verbunden ist, die Ausleseelektrode (5) mit der Bitleitung (12) und die Zwischenschicht (3) mit einer Abschirmleitung (11) verbunden ist, wobei im Falle von seitlichen dotierten Gebieten (6,7,8) für jedes dotierte Gebiet Abschirmleitungen (11) vorhanden sind, wobei die Abschirmleitung (11) der Bitleitung (12) entsprechend ausgeführt ist und die Bitleitungen (12) einen Winkel ungleich Null, vorzugsweise 90°, zu den Wortleitungen (10) bilden.

12. Verfahren zum Beschreiben und Auslesen eines Kapazitiven synaptischen Bauelements nach Anspruch 9
**dadurch gekennzeichnet, dass**

a. bei einer nichtflüchtigen Einstellung der Abschirmung eine Schreibspannung zwischen der Gateelektrode (1) und der Zwischenschicht (3) angelegt wird und eine graduelle Beschreibung in Form der Einstellung verschiedener elektrischer Zustände des aktiven Speichermediums entweder über eine unterschiedliche Schreibpulshöhe (20), Schreibpulsdauer (19) oder Schreibpulsanzahl (21) erzielt werden kann,
b. dass bei einer flüchtigen Einstellung der Abschirmung fallweise an der Zwischenschicht (3) eine Gleichspannung (26) oder eine symmetrische Sperr- oder Durchlassspannung (22) an den pin- oder psn-Übergang angelegt wird, und
c. dass im Falle a) beim Auslesen der kapazitive Kopplung (16) zwischen Gateelektrode (1) und Ausleseelektrode (5) die Zwischenschicht (3) geerdet wird, und/oder im Falle von b) beim Auslesen die Spannungsverhältnisse an der Zwischenschicht (3) wie bei b) geschildert, ausgebildet sind und
d. dass in beiden Fällen a) und b) beim Auslesen an der Gateelektrode (1) ein veränderliches Spannungssignal (15) angelegt wird und an der Ausleseelektrode (5) ein Strom oder eine Ladungsänderung (17) in Abhängigkeit vom Zustand der Abschirmung gemessen wird.

13. Verfahren nach Anspruch 12, **dadurch gekenn-**

zeichnet, dass beim Auslesen die veränderlichen Spannungssignale (15) an alle Wortleitungen (10) parallel angelegt werden und eine gewichtete Multiplikation an den Kreuzungspunkten stattfindet, sowie die Ströme oder die Ladungsänderungen (17) in der Bitleitung (12) sich summieren.

14. Verfahren nach Anspruch 12, **dadurch gekennzeichnet, dass** das Schreiben des aktiven Speichermediums zusätzlich moduliert wird, indem eine symmetrische Sperr- oder Durchlassspannung (22) an den pin- oder psn-Übergang angelegt wird.

15. Verfahren nach Anspruch 12, wobei das Bauelement zur Modellierung eines Sigmoid oder ReLU Neurons dient, **dadurch gekennzeichnet, dass** während des Dropout Algorithmus Bauelemente durch eine symmetrische Sperr- oder Durchlassspannung (22) an dem pin- oder psn-Übergang ein- oder abgeschaltet werden.

16. Verfahren nach Anspruch 12, **dadurch gekennzeichnet, dass** beim Schreiben entweder Fowler-Nordheim Tunneln oder Injektion von heißen Ladungsträgern zum Einsatz kommen, wobei diese im pin- oder psn-Übergang durch Anlegen einer Spannung generiert werden.

**Claims**

1. A capacitive synaptic component, namely a capacitive component for weighted multiplication in artificial neural networks, consisting of a layer structure composed of a gate electrode (1), comprising a first dielectric layer (2) connected to the gate electrode, a second dielectric layer (4) and a readout electrode (5) connected to the second dielectric layer (4)and an intermediate layer (3) arranged between the first dielectric layer (2) and the second dielectric layer (4), **characterized in that** the intermediate layer (3) is embodied as a layer having adjustable shielding behavior in an electric field, proceeding from the gate electrode (1) in the direction toward the readout electrode (5), and the intermediate layer is provided with one or more dedicated contacts that realize a charge inflow into or a charge outflow out of the intermediate layer.

2. The capacitive synaptic component as claimed in claim 1, **characterized in that** the first dielectric layer (2) and/or the intermediate layer (3) are/is embodied as an active storage medium.

3. The capacitive synaptic component as claimed in claim 2, **characterized in that** the first dielectric layer (2) is embodied as an active storage medium storing different charge states.

4. The capacitive synaptic component as claimed in claim 3, **characterized in that** the first dielectric layer (2) in the function as an active storage medium consists of a ferroelectric material (13).

5. The capacitive synaptic component as claimed in claim 3, **characterized in that** the first dielectric layer (2) in the function as an active storage medium has charge traps (14) .

6. The capacitive synaptic component as claimed in claim 2, **characterized in that** the intermediate layer (3) is embodied as an active storage medium storing different resistance values by virtue of the fact that the intermediate layer (3) has a variable resistance (9), and it is embodied so as to store its resistance value in a nonvolatile manner.

7. The capacitive synaptic component as claimed in claim 6, **characterized in that** the intermediate layer consists of a metal-insulator junction material, a memristive material or a phase-change memory.

8. The capacitive synaptic component as claimed in any of claims 1 to 5, **characterized in that** the intermediate layer (3) consists of a semiconductor material and has a nonlinearity in a capacitance-voltage ratio of a capacitive coupling (16) between gate electrode (1) and readout electrode (5).

9. The capacitive synaptic component as claimed in claim 8, **characterized in that** the intermediate layer (3) has lateral highly doped p-type (6) and n-type (7) zones, and the intervening region is only weakly doped or is embodied in intrinsic fashion, with formation of a lateral psn or pin zone.

10. The capacitive synaptic component as claimed in claim 8 or 9, **characterized in that** there is arranged between the first dielectric layer and the readout electrode (5) a semiconductor region having a first partial region, which forms the intermediate layer (3), and a second partial region (25), which is provided with a charge carrier depletion, such that it forms the second dielectric layer (4).

11. An arrangement using a capacitive synaptic component as claimed in any of claims 1 to 10, **characterized in that** a matrix consists of a plurality of capacitive synaptic components in which, from each capacitive synaptic component, the word line (10) is connected to the gate electrode (1), the readout electrode (5) is connected to the bit line (12) and the intermediate layer (3) is connected to a shielding line (11), wherein, in the case of laterally doped zones (6,7,8), shielding lines (11) are present for each doped zone, wherein the shielding line (11) is embodied in a manner corresponding to the bit line (12), and the bit lines (12) form an angle of not equal to zero, preferably 90°, with respect to the word lines (10).

12. A method for writing to and reading from a capacitive synaptic component as claimed in claim 9, **characterized in that**

   a. in the event of a nonvolatile adjustment of the shielding a write voltage is applied between the gate electrode (1) and the intermediate layer (3) and it is possible to achieve graded writing in the form of the adjustment of different electrical states of the active storage medium either by way of a varying write pulse height (20), write pulse duration (19) or write pulse number (21),
   b. in the event of a volatile adjustment of the shielding on a case by case basis at the intermediate layer (3) a DC voltage (26) or a symmetrical reverse or forward voltage (22) is applied to the pin or psn junction, and
   c. in case a) the intermediate layer (3) is grounded during readout of the capacitive coupling (16) between gate electrode (1) and readout electrode (5), and/or in case b) during readout the voltage ratios at the intermediate layer (3) are embodied as outlined in b), and
   d. in both cases a) and b) during readout a variable voltage signal (15) is applied at the gate electrode (1) and a current or a charge change (17) depending on the state of the shielding is measured at the readout electrode (5).

13. The method as claimed in claim 12, **characterized in that** during readout the variable voltage signals (15) are applied to all the word lines (10) in parallel and a weighted multiplication takes place at the crossover points, and the currents or the charge changes (17) in the bit line (12) are summed.

14. The method as claimed in claim 12, **characterized in that** writing to the active storage medium is additionally modulated by a symmetrical reverse or forward voltage (22) being applied to the pin or psn junction.

15. The method as claimed in claim 12, wherein the component serves for modeling a sigmoid or ReLU neuron, **characterized in that** during the dropout algorithm components are switched on or off by means of a symmetrical reverse or forward voltage (22) at the pin or psn junction.

16. The method as claimed in claim 12, **characterized in that** during writing either Fowler-Nordheim tunneling or injection of hot charge carriers are used, wherein said hot charge carriers are generated in the pin or psn junction by means of applying a voltage.

**Revendications**

1. Composant synaptique capacitif, à savoir un composant capacitif destiné à des multiplications pondérées dans des réseaux neuronaux artificiels, composé d'une structure en couches constituée d'une électrode de gâchette (1), comprenant une première couche diélectrique (2) reliée à l'électrode de gâchette, une deuxième couche diélectrique (4) et une électrode de lecture (5) reliée à la deuxième couche diélectrique (4) ainsi qu'une couche intermédiaire (3) disposée entre la première couche diélectrique (2) et la deuxième couche diélectrique (4), **caractérisé en ce que** la couche intermédiaire (3) est réalisée sous la forme d'une couche ayant un comportement de blindage réglable dans un champ électrique, à partir de l'électrode de gâchette (1) en direction de l'électrode de lecture (5), et la couche intermédiaire est pourvue d'un ou plusieurs points de mise en contact propres qui réalisent un afflux de charge dans ou une évacuation de charge depuis la couche intermédiaire.

2. Composant synaptique capacitif selon la revendication 1, **caractérisé en ce que** la première couche diélectrique (2) et/ou la couche intermédiaire (3) est réalisée sous la forme d'un support de mémorisation actif.

3. Composant synaptique capacitif selon la revendication 2, **caractérisé en ce que** la première couche diélectrique (2) est réalisée sous la forme d'un support de mémorisation actif qui mémorise différents états de charge.

4. Composant synaptique capacitif selon la revendication 3, **caractérisé en ce que** la première couche diélectrique (2), dans sa fonction en tant que support de mémorisation actif, se compose d'un matériau ferroélectrique (13).

5. Composant synaptique capacitif selon la revendication 3, **caractérisé en ce que** la première couche diélectrique (2), dans sa fonction en tant que support de mémorisation actif, possède des points de capture de charge (14).

6. Composant synaptique capacitif selon la revendication 2, **caractérisé en ce que** la couche intermédiaire (3) est réalisée sous la forme d'un support de mémorisation actif qui mémorise différentes valeurs de résistance, du fait que la couche intermédiaire (3) présente une résistance variable (9), et elle est configurée pour mémoriser sa valeur de résistance de manière non volatile.

**7.** Composant synaptique capacitif selon la revendication 6, **caractérisé en ce que** la couche intermédiaire se compose d'un matériau de transition métal-isolateur, d'un matériau memristif ou d'une mémoire à changement de phase.

**8.** Composant synaptique capacitif selon l'une des revendications 1 à 5, **caractérisé en ce que** la couche intermédiaire (3) se compose d'un matériau semiconducteur et présente une non-linéarité dans un rapport capacité/tension d'un couplage capacitif (16) entre l'électrode de gâchette (1) et l'électrode de lecture (5).

**9.** Composant synaptique capacitif selon la revendication 8, **caractérisé en ce que** la couche intermédiaire (3) possède des régions latérales fortement dopées P (6) et N (7), et la zone qui se trouve entre celles-ci n'est que faiblement dopée ou formée intrinsèquement en formant une région latérale psn ou pin.

**10.** Composant synaptique capacitif selon la revendication 8 ou 9, **caractérisé en ce qu'**une zone en semiconducteur est disposée entre la première couche diélectrique et l'électrode de lecture (5), laquelle possède une première zone partielle, qui forme la couche intermédiaire (3), et une deuxième zone partielle (25), laquelle est pourvue d'un appauvrissement de porteurs de charges, de sorte qu'elle forme la deuxième couche diélectrique (4).

**11.** Arrangement en utilisant un composant synaptique capacitif selon l'une des revendications 1 à 10, **caractérisé en ce qu'**une matrice se compose d'une pluralité de composants synaptiques capacitifs, avec laquelle chacun des composants synaptiques capacitifs a sa ligne de mots (10) reliée à l'électrode de gâchette (1), l'électrode de lecture (5) reliée à la ligne de bits (12) et la couche intermédiaire (3) à une ligne de blindage (11), des lignes de blindage (11) étant présente pour chaque région dopée dans le cas des régions latérales dopées (6, 7, 8), la ligne de blindage (11) étant réalisée en fonction de la ligne de bits (12) et les lignes de bits (12) formant un angle différent de zéro, de préférence de 90°, par rapport aux lignes de mots (10).

**12.** Procédé pour écrire et lire un composant synaptique capacitif selon la revendication 9, **caractérisé en ce que**

a. lors d'un réglage non volatile du blindage, une tension d'écriture est appliquée entre l'électrode de gâchette (1) et la couche intermédiaire (3) et une écriture graduelle sous la forme du réglage de différents états électriques du support de mémorisation actif peut être obtenue par le biais soit d'une hauteur d'impulsion d'écriture (20), d'une durée d'impulsion de lecture (19) ou d'un nombre d'impulsions de lecture (21) différent(e),

b. **en ce que** lors d'un réglage volatile du blindage, au cas par cas, une tension continue (26) est appliquée à la couche intermédiaire (3) ou une tension de blocage ou de passage (22) symétrique est appliquée à la transition pin ou psn, et

c. **en ce que** dans le cas a), la couche intermédiaire (3) est reliée à la terre lors de la lecture du couplage capacitif (16) entre l'électrode de gâchette (1) et l'électrode de lecture (5) et/ou dans le cas b), lors de la lecture, les rapports de tension au niveau de la couche intermédiaire (3) sont réalisés blindés, comme pour b), et

d. **en ce que** dans les deux cas a) et b), lors de la lecture, un signal de tension (15) variable est appliqué à l'électrode de gâchette (1) et un courant ou un changement de charge (17) en fonction de l'état du blindage est mesuré au niveau de l'électrode de lecture (5).

**13.** Procédé selon la revendication 12, **caractérisé en ce que** lors de la lecture, les signaux de tension (15) variables sont appliqués en parallèle à toutes les lignes de mots (10) et une multiplication pondérée a lieu au niveau des points d'intersection, et aussi les courants ou les changements de charge (17) s'additionnent dans la ligne de bits (12).

**14.** Procédé selon la revendication 12, **caractérisé en ce que** l'écriture du support de mémorisation actif est en plus modulée en appliquant une tension de blocage ou de passage (22) symétrique à la transition pin ou psn.

**15.** Procédé selon la revendication 12, le composant servant à la modélisation d'une sigmoïde ou de neurones de ReLU, **caractérisé en ce que** pendant l'algorithme d'abandon (Dropout), les composants sont mis en circuit ou hors circuit par une tension de blocage ou de passage (22) symétrique au niveau de la transition pin ou psn.

**16.** Procédé selon la revendication 12, **caractérisé en ce que** soit des tunnels de Fowler-Nordheim, soit l'injection de porteurs de charges chauds, sont utilisés lors de l'écriture, ceux-ci étant générés dans la transition pin ou psn par l'application d'une tension.

**Fig. 1**

**Fig. 2**

**Fig. 3**

**Fig. 4**

# Fig. 5

ohne seitlich dotierten Gebieten

mit seitlich dotierten Gebieten

10

11

12

10

11

12

EP 4 062 464 B1

**Fig. 6**

Fig. 7

**Fig. 8**

EP 4 062 464 B1

EP 4 062 464 B1

**Fig. 9**

15

+/-V$_{mod}$

-/+V$_{mod}$

Kapazitive Kopplung

22

17

17

C

22

23

24

V$_G$

Gateelektrodenspannung

15

Fig. 10

Fig. 11

23

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20180019011 A1
- WO 2016068886 A1
- US 5146542 A
- WO 1991018360 A1
- US 20120014170 A1
- WO 2011025495 A1
- DE 102014105639 B3
- US 5524092 A1
- US 2019303744 A1
- WO 002018069359 A1
- US 20180166448 A

**In der Beschreibung aufgeführte Nicht-Patentliteratur**

- **TSAI et al.** *Recent progress in analog memory-based accelerators for deep learning*
- **DI VENTRA et al.** Circuit elements with memory-memristors, memcapacitors, and meminductors. *Proceedings of the IEEE*
- **ZHENG et al.** *Artificial Neural Network Based on Doped HfO2 Ferroelectric Capacitors with Multilevel Characteristics*
- **DRISCOLL et al.** *Memory metamaterials. Gänzlich an der Konzepte basieren auf Bauelemente auf Basis von Ionen*
- **KREMS et al.** *Ionic Memcapacitive Effects in Nano-pores*
- **MARTINEZ et al.** *Solidstate memcapacitor*
- **YANG et al.** *Memristive Physically Evolving Networks Enabling the Emulation of Heterosynaptic Plasticity*